Europäisches Patentamt

European Patent Office

Office européen des brevets

(19)

(11) Veröffentlichungsnummer: **0 102 598**
**B1**

# EUROPÄISCHE PATENTSCHRIFT

(45) Veröffentlichungstag der Patentschrift:
28.01.87

(51) Int. Cl.⁴: **H 04 L 7/02,** H 03 L 7/00

(21) Anmeldenummer: **83108426.4**

(22) Anmeldetag: **22.10.80**

(60) Veröffentlichungsnummer der früheren Anmeldung
nach Art. 76 EPÜ: **0028734**

(54) **Vorrichtung zur Phasensynchronisierung.**

(30) Priorität: **09.11.79 DE 2945331**

(43) Veröffentlichungstag der Anmeldung:
**14.03.84 Patentblatt 84/11**

(45) Bekanntmachung des Hinweises auf die Patenterteilung:
**28.01.87 Patentblatt 87/5**

(84) Benannte Vertragsstaaten:
**DE FR GB IT NL**

(56) Entgegenhaltungen:
**DE - B - 2 301 315**
**DE - B - 2 553 105**
**DE - B - 2 636 150**
**GB - A - 1 382 312**

(73) Patentinhaber: **Nixdorf Computer Aktiengesellschaft,
Fürstenallee 7, D-4790 Paderborn (DE)**

(72) Erfinder: **Hüllwegen, Josef, Hüttenstrasse 61,
D-4791 Altenbeken (DE)**

(74) Vertreter: **Patentanwälte Schaumburg & Thoenes,
Mauerkircherstrasse 31 Postfach 86 07 48,
D-8000 München 80 (DE)**

ACTORUM AG

## Beschreibung

Die Erfindung betrifft eine Vorrichtung zur Phasensynchronisierung nach dem Oberbegriff des Patentanspruchs 1.

Eine solche Vorrichtung eignet sich insbesondere zur Verwendung in Verbindung mit einer Vorrichtung zum Einstellen einer Entzerrerschaltung, wie sie in der EP-Patentanmeldung 80 106 426.2 beschrieben ist.

Bei Datenübertragungssystemen tritt häufig das Problem auf, dass die mit beliebiger Phase in die Empfangsstelle einlaufenden Daten in der Empfangsstelle mittels eines örtlichen Empfängertaktes verarbeitet werden sollen, was eine Phasensynchronisierung zwischen beiden voraussetzt. Die einfachste zu diesem Zweck bekannte Anordnung enthält zwei hintereinandergeschaltete D-Flipflops. Die einlaufenden Daten werden unter der Steuerung eines aus ihnen rückgewonnenen Takts, der zur Unterscheidung vom Empfängertakt nachfolgend Datentakt genannt wird, in das erste Flipflop übernommen und unter der Steuerung durch den Empfängertakt in das zweite Flipflop überschrieben. Diese Anordnung arbeitet nur dann zufriedenstellend, wenn der Datentakt und der Empfängertakt bzw. die Daten und der Empfängertakt nicht zu grosse Phasenverschiebungen aufweisen. Es ist ferner möglich, eine grössere Datenmenge zwischenzuspeichern, um sie dann in bestimmter Weise unter der Steuerung des Empfängertakts wieder abzufragen. Diese Möglichkeit ist jedoch aufwendig und bedarf einer grossen Speicherkapazität. Sie ist darüber hinaus nicht im on-line-Betrieb arbeitsfähig.

Bei einer aus der DE-B-25 53 105 bekannten Vorrichtung zur Phasensynchronisierung wird die Phasendifferenz zwischen dem Datentakt und dem Empfängertakt mit Hilfe eines Phasenvergleichers ermittelt. Der Phasenvergleicher umfasst einen Zähler, der während einer dieser Phasendifferenz entsprechenden Zeitspanne Impulse zählt, so dass nach Ablauf des Zählvorgangs der Zählerstand der Phasendifferenz proportional ist. Der Zählerstand dieses Zählers wird zur Voreinstellung eines weiteren Zählers verwendet, mit Hilfe dessen aus dem Empfängertakt ein entsprechend der festgestellten Phasendifferenz verzögerter Arbeitstakt gewonnen wird. Die Feststellung der Phasendifferenz erfolgt dabei nur ein einziges Mal am Beginn eines Übertragungszyklus.

Diese bekannte mit dem eigentlichen Empfängertakt asynchrone Datenverarbeitung in der Empfangsstelle ist in vielen Fällen unbefriedigend. Aufgabe ist es daher, eine Vorrichtung zu schaffen, bei der nicht der Empfängertakt in die Phasenlage der empfangenen Daten, sondern die empfangenen Daten in die Phasenlage des Empfängertakts umgesetzt werden. Dies lässt sich bei der beschriebenen Vorrichtung erfindungsgemäss durch die Merkmale des Patentanspruchs 1 erreichen.

Bei dem Zähler handelt es sich vorzugsweise um einen Vorwärts/Rückwärts-Zähler, dessen Zählrichtung vom Ausgangssignal des Phasenvergleichers abhängig davon umsteuerbar ist, ob die Phase der empfangenen Daten der des Empfangstaktes voreilt oder nacheilt. Auf diese Weise kann mit einfachen Mitteln eine zumindest quasikontinuierliche Phasensynchronisierung erreicht und Phasenschwankungen, die durch Veränderung der Einstellung des Haupt-Entzerrers entstehen, ausgeglichen werden.

Es ist zwar durch die GB-A-1 382 312 die Umsetzung der empfangenen Daten in die Phasenlage des Empfängertaktes mittels einer gesteuerten Verzögerungseinrichtung an sich bekannt. Die Gewinnung des Steuersignals für die Verzögerungseinrichtung, also des Signals, welches abhängig ist von dem aktuellen Phasenunterschied zwischen dem empfangenen Datensignal und dem Empfängertakt, erfolgt hierbei aber nicht mittels eines Zählers.

Eine mit geringem Schaltungsaufwand herstellbare Phasenvergleichsschaltung umfasst erfindungsgemäss einen ersten Untersetzer, der den Datentakt im Verhältnis 1:2 untersetzt, einen zweiten Untersetzer, der den Empfängertakt im Verhältnis 1:2 untersetzt, ein D-Flipflop, dessen D-Eingang mit dem Ausgang des ersten Untersetzers verbunden ist, ein NAND-Glied, dessen einer Eingang mit dem Ausgang des zweiten Untersetzers und dessen anderer Eingang über ein Nicht-Glied mit dem Eingang des zweiten Untersetzers verbunden sind und dessen Ausgang mit dem Takteingang des D-Flipflops verbunden ist. Wenn sich bei diesem Aufbau der Phasenvergleichsschaltung das Vorzeichen der Phasendifferenz umkehrt, dann kehrt sich auch das Ausgangssignal des D-Flipflops um, das somit zur Steuerung der Zählrichtung des Vorwärts/Rückwärts-Zählers geeignet ist.

Die Erfindung wird im folgenden an Hand von Ausführungsbeispielen unter Bezug auf die beiliegenden Zeichnungen näher erläutert. Es zeigen:

Fig. 1 ein Blockschaltbild einer ersten Ausführungsform einer Phasensynchronisiervorrichtung und

Fig. 2 ein Blockschaltbild einer zweiten Ausführungsform einer Phasensynchronisiervorrichtung.

Es ist oft zweckmässig, die Phasenlage der aus dem entzerrten Eingangssignal nach Demodulation gewonnenen Daten in den Synchronzustand mit einem örtlichen Empfängertakt der Empfangsstelle zu verschieben, anstatt einen mit der Datenphase übereinstimmenden Verarbeitungstakt zu erzeugen. Der örtliche Empfängertakt stimmt in der Frequenz relativ genau mit dem Datentakt überein, die jeweiligen Phasen sind aber nicht korreliert.

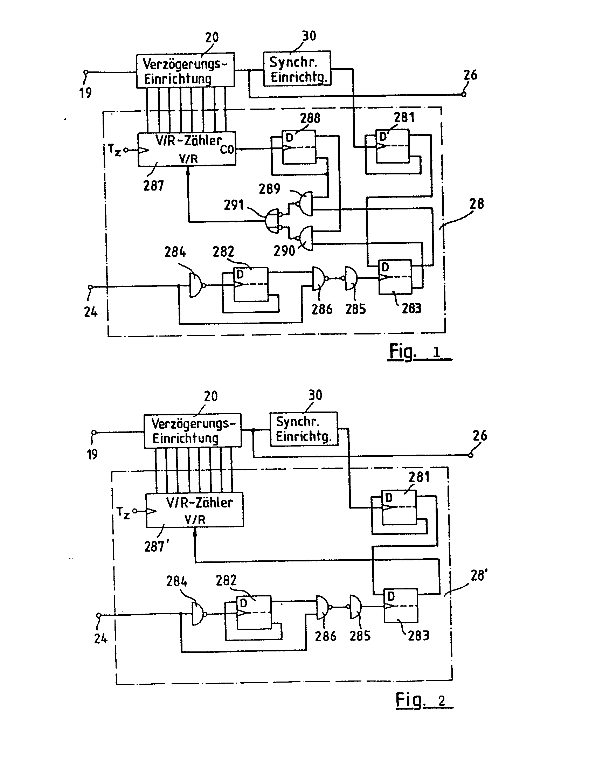

Die Vorrichtung gemäss Fig. 1 enthält als wesentliches Element einen Phasenschieber bzw. eine Verzögerungseinrichtung 20, die am Anschluss 19 die zu verarbeitenden Daten empfängt und diese Daten mit einer bestimmten Phasenverschiebung an den Ausgangsanschluss 26 liefert. Die Synchroneinrichtung 30, die mit dem Ausgang der Verzögerungseinrichtung 20 verbunden ist, leitet aus den phasenverschobenen Daten den entsprechend phasenverschobenen Datentakt ab. Es ist einfacher, die Phasendifferenz zwischen diesem Datentakt und dem Empfängertakt als direkt zwischen dem Empfängertakt und den Daten zu ermitteln. Die Verzögerungseinrichtung kann nach dem Prinzip einer aus der DE-B-24 10 957 an sich bekannten Schaltungsanordnung aufgebaut sein und eine digital programmierbare monostabile Kippstufe, bestehend aus einem 8-Bit-Zähler in Verbindung mit einem Flipflop, enthalten. Da die Phasendifferenz zwischen dem Empfängertakt und den Daten bzw. dem Datentakt sehr unterschiedlich sein kann und zwischen Null und einer gesamten Bitzeit schwanken kann, ist es zweckmässig, die mittlere Verzögerungszeit zum 1,5fachen der Bitzeit zu wählen. Da die erwähnte bekannte Schaltungsanordnung eine Verzögerung um höchstens eine Bitzeit zulässt, sind im vorliegenden Fall zwei derartige Schaltungsanordnungen hintereinander zu schalten. Grundsätzlich lässt sich diese Verzögerungseinrichtung auch in analoger Form ausführen. Die digitale Ausführung hat jedoch den Vorteil, dass sie präzise arbeitet und dass beim Umschalten auf andere Datenübertragungsgeschwindigkeiten lediglich die Taktfrequenz der Zähler in der Verzögerungseinrichtung entsprechend umgeschaltet zu werden brauchen. Die Zähler in der Verzögerungseinrichtung sind voreinstellbare Zähler, und die gesamte Verzögerungszeit hängt von dieser Voreinstellung ab. Statt einer solchen Schaltungsanordnung könnte auch ein Schieberegister als Verzögerungseinrichtung verwendet werden.

Die Phasenvergleichsschaltung der Stelleinrichtung 28 umfasst bei der dargestellten Ausführungsform drei D-Flipflops 281, 282 und 283 sowie zwei Inverter oder Nicht-Glieder 284, 285 und ein NAND-Glied 286. Das Flipflop 281 wird von der Synchroneinrichtung 30 mit dem Datentakt gespeist und untersetzt diesen im Verhältnis 1:2. Die diesem Zweck dienende Beschaltung des D-Flipflops ist aus der Darstellung erkennbar und braucht nicht erläutert zu werden. Der Empfängertakt gelangt vom Anschluss 24 über das Nicht-Glied 284 auf den Takteingang des Flipflops 282, das eine Untersetzung des Empfängertakts im Verhältnis 1:2 bewirkt. Ein Eingang des NAND-Glieds 286 ist mit dem Ausgang des Flipflops 282, der andere Eingang des NAND-Glieds 286 mit dem Anschluss 24 verbunden. Der Ausgang des NAND-Glieds 286 ist über das Nicht-Glied 285 mit dem Takteingang des Flipflops 283 verbunden, an dessen D-Eingang der Ausgang des Flipflops 281 angeschlossen ist. Die Wirkung dieser Schaltung ist, dass sich der Zustand des Flipflops 283 jedesmal dann umkehrt, wenn sich das Vorzeichen der Phasendifferenz zwischen dem Datentakt von der Synchroneinrichtung 30 und dem Empfängertakt am Anschluss 24 ändert, wenn also die Phasennacheilung des Empfängertakts gegenüber dem Datentakt zu einer Phasenvoreilung wird oder umgekehrt. Die Stelleinrichtung 28 umfasst ferner einen Vorwärts/Rückwärts-Zähler 287, dessen Eingang mit einem Zähltakt Tz beaufschlagt ist, dessen Folgefrequenz gross gegenüber derjenigen vom Datentakt und Empfängertakt ist. Dieser Zähltakt liegt ständig am Zähler 287 an.

Die vorstehende Beschreibung gilt sowohl für die Stelleinrichtung 28 nach Fig. 1 als auch für die Stelleinrichtung 28' nach Fig. 2. Die Stelleinrichtung 28 von Fig. 1 besitzt ein weiteres D-Flipflop 288, das jeweils eine Umschaltung der Zähleinrichtung des Zählers 287 über Nand-Glieder 289, 290 und 291 bewirkt, wenn der Zähler vollgelaufen ist oder sein Zählerstand Null geworden ist und am Übertragungsanschluss CO ein Ausgangsimpuls erscheint. Die Stelleinrichtung 28' von Fig. 2 ist demgegenüber dadurch vereinfacht, dass ein Zähler 287' verwendet wird, der bei Überschreitung seiner Kapazität sich automatisch auf Null zurückstellt. Die prinzipielle Wirkungsweise beider Ausführungsformen der Schaltung ist abgesehen von diesem Unterschied dieselbe und soll nachfolgend erläutert werden. Es sei angenommen, dass die Phasendifferenz zwischen dem Datentakt und dem Empfängertakt positiv sei, was bedeuten möge, dass die Phase des Datentakts derjenigen des Empfängertakts voreilt. Zur Phasenanpassung muss dann die Phasenverschiebung mittels der Verzögerungseinrichtung vergrössert werden. Bei dieser positiven Phasendifferenz bewirkt der Zustand des Flipflops 283, dass der Zähler 287 (287') in Vorwärtsrichtung zählt. Sein Zählerstand erhöht sich daher mit jedem Impuls des Zähltakts Tz. Ein erhöhter Zählerstand des Zählers 287 (287') führt zu einer entsprechend stärkeren Verzögerung durch die Verzögerungseinrichtung 20. Die vom Phasenvergleicher festgestellte Phasendifferenz nimmt daher ab und wird irgendwann den Wert Null erreichen und dann negativ werden. Dieser Vorzeichenwechsel führt zu einer Zustandsänderung des Flipflops 283 und damit zu einer Änderung der Zählrichtung des Zählers 287 (287'). Dadurch wird die Verzögerung mittels der Verzögerungseinrichtung 20 wieder vermindert, bis erneut ein Vorzeichenwechsel der Phasendifferenz auftritt. Auf diese Weise pendelt die Verzögerung durch die Verzögerungseinrichtung 20 um einen solchen Wert, dass die Phasendifferenz zwischen den empfangenen Daten und dem Empfängertakt im Mittel Null ist.

In einem Entzerrersystem, an das die Phasensynchronisiervorrichtung angeschlossen sein kann, arbeiten Regelkreise, die einen Einfluss auf die Phase haben und deren Regelungskriterien phasenabhängig sind. Die Synchroneinrichtung 30 kann weitere Regelkreise enthalten, wenn sie den jeweiligen Datentakt nicht direkt aus dem Datensignal erzeugt, sondern eine eigene Zeitbasis besitzt, die mit Hilfe des Datensignals frequenz- und phasengeregelt wird. Wenn die Synchroneinrichtung digital ausgeführt ist, bleiben am Ausgang sprungweise Schwankungen des Datentakts entsprechend der Auflösung der digitalen Schaltung übrig, die nicht ausgeregelt werden können. Da auch die Verzögerungseinrichtung und der Phasenvergleicher digital aufgebaut sind, bleibt auch hier, abhängig von der Auflösung der Schaltung, eine variierende Phasendifferenz übrig. Zur Erreichung einer stabilen Regelung ist es deshalb erforderlich, dass die verschiedenen Regelkreise mit so weit unterschiedlichen Zeitkonstanten arbeiten, dass keine Regelschwingungen auftreten. Weiterhin müssen die Zeitkonstanten so gewählt werden, dass die statistischen Einflüsse der Störungen auf die Phase weitgehend beseitigt werden, und eine eindeutige Regelung zum Optimum hin erfolgt. Die Zeitkonstante, mit welcher der Zähler 287 (287') um den optimalen Zählerstand pendelt, ist wesentlich grösser als die Regelzeit der Synchroneinrichtung.

**Patentansprüche**

1. Vorrichtung zur Phasensynchronisierung zwischen empfangenen Daten und dem örtlichen Empfängertakt einer Empfangsstelle in einer Datenübertragungsanlage, umfassend einen Phasenvergleicher zum Vergleich eines aus den empfangenen Daten rückgewonnenen Datentakts mit dem Empfängertakt, einen die Phasendifferenz in Form eines Zählerstands speichernden Zähler (287) und eine Verzögerungseinrichtung (20) mit einer vom Zählerstand abhängenden Verzögerung, dadurch gekennzeichnet, dass die Phasendifferenz kontinuierlich ermittelbar und der Zählerstand entsprechend nach oben oder unten korrigierbar ist und dass die Verzögerungseinrichtung (20) die empfangenen Daten entsprechend der Phasendifferenz verzögert.

2. Vorrichtung nach Anspruch 1, dadurch gekennzeichnet, dass der Zähler ein Vorwärts/Rückwärts-Zähler (287; 287') ist, dessen Zählrichtung vom Ausgangssignal des Phasenvergleichers (281 bis 286) abhängig davon umsteuerbar ist, ob die Phase der empfangenen Daten der des Empfangstakts voreilt oder nacheilt.

3. Vorrichtung nach einem der vorhergehenden Ansprüche, dadurch gekennzeichnet, dass die Phasenvergleichsschaltung umfasst: einen ersten Untersetzer (281), der den Datentakt im Verhältnis 1:2 untersetzt, einen zweiten Untersetzer (282), der den Empfängertakt im Verhältnis 1:2 untersetzt, ein D-Flipflop (283), dessen D-Eingang mit dem Ausgang des ersten Untersetzers verbunden ist, und ein NAND-Glied (286), dessen Eingang mit dem Ausgang des zweiten Untersetzers, dessen anderer Eingang über ein Nicht-Glied (284) mit dem Eingang des zweiten Untersetzers und dessen Ausgang über ein weiteres Nicht-Glied (285) mit dem Takteingang des D-Flipflops (283) verbunden sind.

**Claims**

1. A device for synchronizing the phases between received data and the local receiver clock pulse of a receiving station in a data communication system, comprising a phase comparator for comparing a data clock pulse recovered from the received data with the receiver clock pulse, a counter (287) storing the phase difference in the form of a count, and a delay device (20) with a delay depending on the count, characterized in that the phase difference can be continuously determined and the count can be corrected correspondingly to a higher or lower value, and that the delay device (20) delays the received data in correspondence with the phase difference.

2. Device as claimed in Claim 1, characterized in that the counter is an up/down counter (287, 287'), the counting direction of which is reversible by the output signal of the phase comparator (281 to 286), depending on whether the phase of the received data precedes or succeeds the phase of the receiver clock pulse.

3. Device as claimed in any one of the preceding claims, characterized in that the phase comparator circuit comprises: a first step down device (281) for reducing the data clock pulse rate in the ratio 1:2, a second step down device (282) for reducing the receiver clock pulse rate in the ratio 1:2, a D-flip-flop (283) the D-input of which is connected to the output of the first step down device (281), and a NAND element (286) the input of which is connected to the output of the second step down device (282), the other input of which is connected to the input of the second step down device (282) via a NOT element (284), and the output of which is connected to the clock input of the D-flip-flop (283) via a further NOT element (285).

**Revendications**

1. Dispositif pour la synchronisation de phase entre des données reçues et le rythme de réception local d'un poste récepteur dans une installation de transmission des données, comportant un comparateur de phases pour comparer un rythme de données récupéré des données reçues avec le rythme de réception, un compteur (287) mémorisant la différence de phases sous la forme d'une position de compteur, et un retardeur (20) ayant un retard dépendant d'une position de compteur, caractérisé en ce que la différence de phases peut être calculée en continu et la position de compteur peut être corrigée en correspondance, vers le haut ou vers le bas, et le retardeur (20) retarde les données reçues en fonction de la différence de phases.

2. Dispositif selon la revendication 1, caractérisé en ce que le compteur est un compteur-décompteur (287; 287'), dont le sens de comptage peut être commuté par le signal de sortie du comparateur de phases (281 à 286) selon que la phase des données reçues est en avance ou en retard.

3. Dispositif selon l'une des revendications précédentes, caractérisé en ce que le montage de comparaison de phases comporte: un premier circuit binaire (281) qui réduit le rythme de données dans le rapport 1:2, un second circuit binaire (282) qui réduit le rythme de réception dans le rapport 1:2, une bascule D (283) dont l'entrée D est reliée à la sortie du premier circuit binaire, et un élément NON/ET (286) dont l'entrée est reliée à la sortie du second circuit binaire, dont l'autre entrée est reliée par l'intermédiaire d'un élément NON (284) à l'entrée du second circuit binaire et dont la sortie est reliée par l'intermédiaire d'un autre élément NON (285) à l'entrée de rythme de la bascule D (283).

Fig. 1

Fig. 2